Europäisches Patentamt

European Patent Office

Office européen des brevets

(19)

(11) **EP 0 875 000 B1**

(12) **EUROPÄISCHE PATENTSCHRIFT**

(45) Veröffentlichungstag und Bekanntmachung des Hinweises auf die Patenterteilung:
**12.04.2000 Patentblatt 2000/15**

(21) Anmeldenummer: **96915958.1**

(22) Anmeldetag: **31.05.1996**

(51) Int Cl.⁷: **G01R 33/09**

(86) Internationale Anmeldenummer:
**PCT/DE96/00963**

(87) Internationale Veröffentlichungsnummer:
**WO 96/38740 (05.12.1996 Gazette 1996/53)**

(54) **MAGNETISIERUNGSVORRICHTUNG FÜR MAGNETORESISTIVE DÜNNSCHICHT-SENSORELEMENTE IN EINER BRÜCKENSCHALTUNG**

DEVICE FOR MAGNETISING MAGNETORESISTIVE THIN FILM SENSOR ELEMENTS IN A BRIDGE CONNECTION

DISPOSITIF D'AIMANTATION D'ELEMENTS CAPTEURS MAGNETORESISTIFS A COUCHE MINCE DANS UN MONTAGE EN PONT

(84) Benannte Vertragsstaaten:
**DE FR GB IT**

(30) Priorität: **01.06.1995 DE 19520178**

(43) Veröffentlichungstag der Anmeldung:
**04.11.1998 Patentblatt 1998/45**

(73) Patentinhaber: **SIEMENS AKTIENGESELLSCHAFT
80333 München (DE)**

(72) Erfinder:
• **VAN DEN BERG, Hugo
D-91074 Herzogenaurach (DE)**
• **SCHELTER, Wolfgang
D-91080 Uttenreuth (DE)**

(56) Entgegenhaltungen:
**DE-A- 3 442 278**

• **SOVIET INVENTIONS ILLUSTRATED, Part I-III Complete, Woche X25, ver!ffentlicht 1976, 28 Juli, DERWENT PUBLICATIONS LTD., London; & SU,A,485 500 (ELTRN. CONTROL EQUIP.).**

**Beschreibung**

Die Erfindung bezieht sich auf eine Vorrichtung zur Einstellung der Magnetisierungen der Biasschichtteile in zu einer Brücke verschalteten Sensorelementen, die jeweils mit demselben Dünnschichtaufbau auf einem gemeinsamen Substrat angeordnet sind und einen gegenüber einem AMR-Sensorelement erhöhten magnetöresistiven Effekt zeigen.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen Schichten auftretenden Effekt nennt man anisotropen Magnetowiderstand "AMR" oder anisotropen magnetoresistiven Effekt. Er beruht physikalisch auf den unterschiedlichen Streuquerschnitten von Elektronen mit unterschiedlichem Spin und der Spinpolarität des D-Bandes. Die Elektronen werden deshalb als Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Stromrichtung kann dann einige Prozent des normalen isotropen (= ohmschen) Widerstandes betragen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dikken der einzelnen Schichten sind dabei deutlich geringer als die mittlere freie Weglänge der Leitungselektronen gewählt. In solchen Mehrschichtensystemen kann nun zusätzlich zu dem erwähnten anisotropen magnetoresistiven Effekt AMR ein sogenannter giant-magnetoresisiver Effekt oder Giant-Magnetowiderstand GMR auftreten (vgl. z.B. EP 0 483 373 A1). Ein solcher GMR-Effekt beruht auf der unterschiedlich starken Streuung von Majoritäts- und Minoritäts-Leitungselektronen an den Grenzflächen zwischen den ferromagnetischen Schichten und den benachbarten Zwischenschichten sowie auf Streueffekten innerhalb der Schichten, insbesondere bei Verwendung von Legierungen. Der GMR-Effekt ist dabei ein isotroper Effekt. Er kann erheblich größer sein als der anisotrope Effekt AMR und Werte bis zu 70 % des normalen isotropen Widerstandes annehmen. In entsprechenden einen GMR-Effekt zeigenden Mehrschichtensystemen sind benachbarte metallische Magnetschichten zunächst entgegengesetzt magnetisiert, wobei eine Biasschicht bzw. ein Biasschichtteil magnetisch härter als eine Meßschicht ist. Unter dem Einfluß eines äußeren Magnetfeldes kann sich dann die anfängliche antiparallele Ausrichtung der Magnetisierungen in eine parallele umwandeln. Bei entsprechenden Magnetfeldsensoren wird diese Tatsache ausgenutzt.

Aus dem DE 93 12 674.3 U1 geht ein Magnetfeldsensor hervor, der zu einer Wheatstone-Brücke verschaltete Sensorelemente aufweist. Diese Sensorelemente zeigen einen anisotropen Magnetowiderstand AMR. In der Brückenschaltung eines solchen Sensors läßt sich gezielt die Tatsache ausnützen, daß in den einzelnen Sensorelementen der magnetoresistive Effekt der AMR-Schichten vom Winkel zwischen der Magnetisierung der jeweiligen Schicht und der Richtung eines durch sie fließenden Stromes abhängt. Die einzelnen Sensorelemente können durch entsprechende Strukturierung so zu der Brücke verschaltet werden, daß die Stromrichtungen in den beiden paarweise diagonalen Brückenelementen aus den beiden Brückenzweigen unter einem vorbestimmten Winkel verlaufen.

Wollte man entsprechende Brückenschaltungen mit Dünnschicht-Sensorelementen aufbauen, die einen GMR-Effekt zeigen, so ergibt sich das Problem, daß bei derartigen Elementen keine Abhängigkeit des magnetoresistiven Effektes von der Richtung des über das jeweilige Element fließenden Stromes gegeben ist. Das Vorzeichen der Widerstandsänderung ist deshalb bei einheitlicher Magnetisierung der Biasschichtteile und der Meßschichten dieser Elemente für alle Elemente gleich. Sensorelemente mit GMR-Effekt könnten deshalb nur dann zu einer Wheatstone-Brücke verschaltet werden, wenn für die Paare diagonaler Brückenelemente unterschiedliche Magnetisierungsrichtungen ihrer Biasschichtteile einstellbar wären. Bei den für entsprechende Sensoren geforderten äußerst geringen Abmessungen, die im Millimeter-Bereich oder darunter liegen, wurde jedoch bisher keine einfache, in technischem Maßstab praktikable Möglichkeit offenbart, auf derart engem Raum unterschiedliche Magnetisierungsrichtungen in den Biasschichtteilen benachbarter Elemente einzustellen.

Aus "IEEE Transactions on Magnetics", Vol. 29, No. 6, Nov. 1993, Seiten 2705 bis 2710 sind GMR-Materialien für verschiedene Schwachfeld-Anwendungen zu entnehmen. Diese Materialien können in Form von entsprechenden magnetoresistiven Sensorelementen zu einer Brücke verschaltet sein. Die Sensorelemente weisen dabei jeweils ein Mehrschichtensystem aus dünnen magnetischen und nicht-magnetischen Schichten auf, wobei einzelne magnetische Schichten auch unterschiedliche magnetische Härte besitzen können.

Aufgabe der vorliegenden Erfindung ist es deshalb, eine Vorrichtung anzugeben, mit der auf verhältnismäßig einfache Weise die Orientierungen der Magnetisierungen der Biasschichtteile in zu einer Brücke verschalteten Sensorelementen, die mit jeweils demselben Dünnschichtaufbau auf einem gemeinsamen Substrat nebeneinander angeordnet sind und einen erhöhten magnetoresistiven Effekt zeigen, einzustellen sind.

Diese Aufgabe wird erfindungsgemäß mit den in Anspruch 1 angegebenen Maßnahmen gelöst. Dementsprechend ist die Vorrichtung zur Einstellung der Magnetisierung der Bias-Schichtteile in zu einer Brücke verschalteten magnetoresistiven Sensorelementen vorgesehen, die jeweils mit demselben Dünnschichtaufbau auf einem gemeinsamen Substrat angeordnet sind und einen gegenüber einem AMR-Sensorelement erhöhten magnetoresistiven Effekt zeigen. Die Vorrichtung soll dabei

- mehrere von den Sensorelementen räumlich getrennte Leiterbahnteile mit einer solchen Anordnung aufweisen, daß bei einer vorbestimmten Position der Leiterbahnteile bezüglich der Sensorelemente der Brückenschaltung jeweils ein Leiterbahnteil mindestens einem Sensorelement zugeordnet ist, und
- Mittel zur Führung eines Einstellstromes vorbestimmter Richtung und Stärke derart über jeden Leiterbahnteil enthalten, daß in dem Biasschichtteil des jeweils mindestens einen zugeordneten Sensorelementes eine vorbestimmte Orientierungsrichtung der Magnetisierung fest einstellbar ist.

Die mit dieser Ausgestaltung der Vorrichtung verbundenen Vorteile sind insbesondere darin zu sehen, daß erstmalig eine für einen großtechnischen Einsatz mit vertretbarem Aufwand realisierbare Möglichkeit geschaffen ist, GMR-Sensorelemente mit gleichem Aufbau in einer Brückenschaltung äußerst geringer Abmessungen auszubilden. Denn mittels der Einstellströme durch die den einzelnen Sensorelementen jeweils zugeordneten Leiterbahnteile lassen sich auf engstem Raum Magnetisierungen mit vorbestimmten Orientierungen in den jeweiligen Biasschichtteilen der einzelnen Sensorelemente auf einfache Weise "fixieren". Dabei kann der Biasschichtteil sowohl aus einer einzigen, magnetisch härteren Biasschicht oder aus einem Biasschichtensystem, welches insbesondere auch als ein künstlicher Antiferromagnet (vgl. DE 42 43 358 A1) ausgebildet sein kann, bestehen. Mit der erfindungsgemäßen Magnetisierungsvorrichtung wird also der gegenüber anderen magnetischen Schichten eines Sensorelementes magnetisch härtere Biasschichtteil mittels des von dem jeweiligen Einstellstrom hervorgerufenen Magnetfeldes in vorteilhaft einfacher Weise einmalig in einer vorbestimmten Orientierungsrichtung aufmagnetisiert. Der jeweilige Einstellstrom ist dabei so hoch zu wählen, daß mit ihm ein für die Aufmagnetisierung des Biasschichtteils hinreichend starkes Magnetfeld zu erhalten ist. Das Magnetfeld des Einstellstromes kann dabei gegebenenfalls von einem äußeren Stütz- oder Hilfsfeld überlagert sein. Demgegenüber ist aufgrund der vorbestimmten magnetischen Härte (Koerzitivfeldstärke) des Biasschichtteils eine zu detektierende äußere Magnetfeldkomponente zu einer Ummagnetisierung des Biasschichtteils nicht in der Lage.

Vorteilhafte Ausgestaltungen der erfindungsgemäßen Einstellvorrichtung gehen aus den sich dem Hauptanspruch unterordnenden Ansprüchen hervor.

Zur weiteren Erläuterung der Erfindung wird nachfolgend auf die Zeichnung Bezug genommen. Dabei zeigen jeweils schematisch

| Figur 1 | das Schaltbild einer Brückenschaltung eines Magnetfeldsensors mit GMR-Sensorelementen, |
|---|---|
| Figur 2 | einen Querschnitt durch eine erfindungsgemäße Magnetisierungsvorrichtung im Bereich eines Brückenelementes eines solchen Sensors, |
| Figur 3 | eine Schrägansicht auf einen Teil einer entsprechenden Magnetisierungsvorrichtung mit Magnetfeldsensor, |
| Figur 4 | eine Aufsicht auf die Vorrichtung nach Figur 3, |
| Figur 5 | die Hysteresiskurve eines Biasschichtteils eines Sensorelementes eines Magnetfeldsensors, |
| Figur 6 und | eine Magnetisierungsvorrichtung unter Zugrundelegung dieser Hysteresiskurve |
| Figur 7 | eine weitere Ausführungsform einer erfindungsgemäßen Magnetisierungsvorrichtung. |

In den Figuren sind sich entsprechende Teile mit denselben Bezugszeichen versehen.

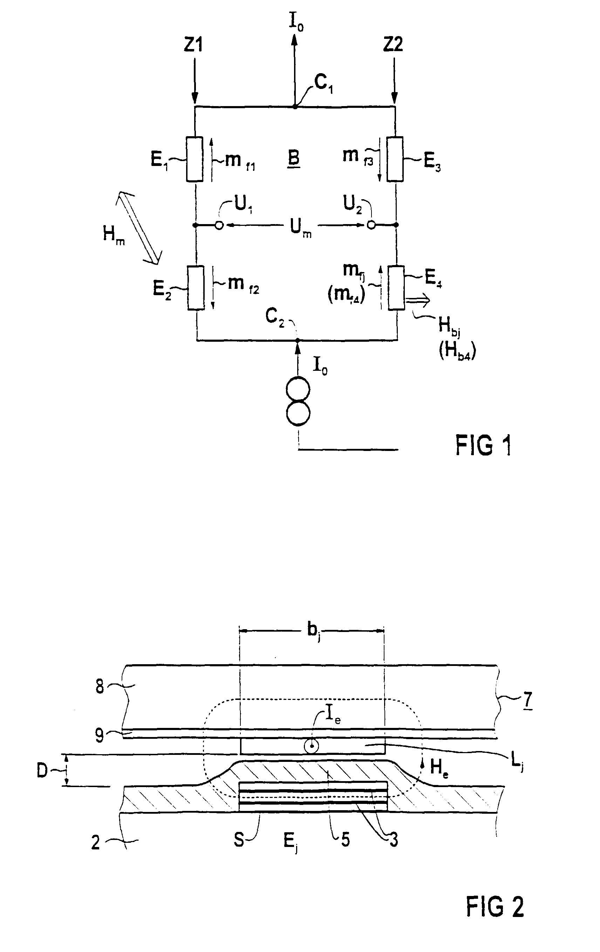

Die erfindungsgemäße Vorrichtung ist zur Einstellung der Magnetisierungen der Biasschichtteile in zu einer Brücke verschalteten GMR-Sensorelementen eines Magnetfeldsensors vorgesehen. Die entsprechende, an sich bekannte Brückenschaltung dieses Sensors geht aus Figur 1 hervor. Die gezeigte Brücke B enthält zwei Brückenzweige Z1 und Z2, die zwischen zwei Anschlußpunkten $C_1$ und $C_2$ der Brücke parallelgeschaltet sind. Über die Brücke B soll an den Anschlußpunkten $C_1$ und $C_2$ ein Brückenstrom $I_0$ geführt werden. Jeder der Brückenzweige Z1 und Z2 enthält zwei in Reihe geschaltete Sensorelemente $E_1$ und $E_2$ bzw. $E_3$ und $E_4$. Zwischen den beiden Elementen jedes Brückenzweiges liegt je ein Meßpunkt $U_1$ bzw. $U_2$ der Brücke. An diesen Meßpunkten kann eine Meßspannung $U_m$ abgenommen werden.

Die einzelnen Sensorelemente $E_j$ (mit $1 \leq j \leq 4$) der Brückenschaltung B sollen aus an sich bekannten magnetoresistiven Mehrschichtensystemen, die einen GMR-Effekt zeigen, aufgebaut sein (vgl. z.B. EP 0 483 373 A1 oder die DE 42 32 244 A1, DE 42 43 357 A1 oder DE 42 43 358 A1). Mit der Brückenschaltung der Sensorelemente läßt sich in Abhängigkeit von einer äußeren Magnetfeldkomponente ein zumindest weitgehend temperaturkompensiertes und hinsichtlich mechanischer Spannungen kompensiertes Meßsignal erhalten. Dies wird durch den gleichen Dünnschichtaufbau der einzelnen Sensorelemente auf dem gemeinsamen Substrat erreicht. Unter einem Schichtaufbau sei hierbei verstanden, daß jedes Sensorelement eine vorbestimmte Schichtenfolge mit vorbestimmter Dicke der einzelnen Schichten aufweist. Die Schichtenfolgen und die Dicken sich entsprechender Schichten aus allen Sensorelementen sind dabei gleich. Derartige Schichtenfolgen lassen sich vorteilhaft einfach realisieren. Alle Sensorelemente $E_j$ weisen jeweils einen Biasschichtteil mit einer vorbestimmten Orientierungsrichtung der Magnetisierung $m_{fj}$ auf. In der Figur 1 sind diese Magnetisierungen durch gepfeilte Linien an den einzelnen Sensorelementen veranschaulicht. Wie aus der Figur hervorgeht, haben die beiden Paare $E_1$-$E_4$ und $E_2$-$E_3$ diagonaler Sensorelemente jeweils gleiche Orientierungsrichtungen der Biasmagnetisierungen $m_{fj}$, wobei die Magnetisierungsrichtung des einen Paares entgegengesetzt zu der des anderen Paares verläuft. Ferner enthalten die einzelnen Mehrschichtsysteme jeweils eine gegenüber dem Biasschichtteil magnetisch weichere Meßschicht, die von diesem Biasschichtteil durch eine nicht-magnetische Zwischenschicht getrennt ist.

Ein entsprechendes Schichtensystem mit GMR-Effekt kann z.B. das Grundsystem zu einer Ausbildung eines Sensorelementes $E_j$ sein. Vorzugsweise weisen die beispielsweise streifenförmigen Sensorelemente $E_j$ jeweils eine Vielzahl von entsprechenden magnetischen und nicht-magnetischen Schichten auf. Ein derartiges Mehrschichtensystem sei für das Sensorelement $E_j$ angenommen, das in Figur 2 angedeutet ist. Sein auf einem Substrat 2 ausgebildetes Mehrschichtensystem S, das beispielsweise einen Biasschichtteil 3 mit mehreren Biasschichten umfaßt, ist mit einer Passivierungsschicht 5 abgedeckt, welche aus einem nichtmagnetischen und insbesondere isolierenden Material besteht. Das Sensorelement $E_j$ braucht nicht unbedingt mit seinem Mehrschichtensystem eine rechteckige Grundfläche auf dem Substrat 2 einzunehmen. So kann z.B. auch eine Mäanderform vorgesehen werden. Zur Verschaltung der einzelnen Sensorelemente $E_j$ zu einer Brückenschaltung B gemäß Figur 1 wird jedes Element mit seinem GMR-Schichtsystem mit wenigstens zwei Kontakten versehen. Diese Kontakte werden entweder beide auf der obersten Meßschicht des entsprechenden magnetfeldempfindlichen Schichtensystems angeordnet, so daß der Brückenstrom im Mittel parallel zu den Schichtebenen fließt (sogenanntes "Current-in-Plane (CIP)-System"); oder es wird jeweils ein Kontakt auf der obersten und auf der untersten Schicht angeordnet, so daß dann der Brückenstrom im Mittel senkrecht zu den Schichtebenen fließt (sogenanntes "Current-Perpendicular-to-Plane (CPP)-System". In Figur 2 sind jedoch elektrische Anschlußkontakte an dem Mehrschichtensystem aus Gründen der Übersichtlichkeit weggelassen.

Zu einer Magnetisierung des Biasschichtteils 3 jedes Sensorelementes $E_j$ mit vorbestimmter Form seiner Grundfläche und mit einer vorbestimmten Orientierungsrichtung der Magnetisierung ist eine erfindungsgemäße Einstellvorrichtung 7 vorgesehen. Diese Vorrichtung weist gemäß Figur 2 einen Leiterbahnträger 8 auf, an dessen den einzelnen Sensorelementen $E_j$ zugewandter Unterseite Leiterbahnteile $L_j$ aus einem elektrisch gut leitenden Material wie Cu oder Ag angeordnet sind. Gegebenenfalls ist zwischen dem Leiterbahnträger 8 und den einzelnen Leiterbahnteilen $L_j$ eine Isolationsschicht 9 vorgesehen. Die Leiterbahnteile $L_j$ sollen so an der Unterseite des Leiterbahnträgers 8 angeordnet sein, daß bei einem Positionieren des Trägers 8 oberhalb der Brückenschaltung jeweils ein Leiterbahnteil $L_j$ vorzugsweise zumindest annähernd parallel zu wenigstens einem ihm zugeordneten Sensorelement $E_j$ verläuft. Die jeweilige Leiterbahnbreite $b_j$ ist im allgemeinen nicht viel größer als die Breite des Schichtensystems S des zugeordneten Sensorelements $E_j$ zu wählen, um eine gegenseitige Beeinflussung eng benachbarter Leiterbahnteile mit unterschiedlichen Stromflußrichtungen zu vermeiden. Mit einem Einstellstrom $I_e$ durch jeden Leiterbahnteil $L_j$ läßt sich dann ein magnetisches Einstellfeld $H_e$ solcher Richtung und Stärke hervorrufen, daß in dem Biasschichtteil 3 des zugeordneten Mehrschichtensystems S eine Vorzugsrichtung der Magnetisierung fixierbar ist. Bei dieser Magnetisierung sollte vorzugsweise der Abstand D zwischen einem Leiterbahnteil $L_j$ und dem jeweils zugeordneten Mehrschichtensystem S kleiner als die Leiterbahnbreite $b_j$ wählbar sein, da sonst große Stärken des Einstellstromes $I_e$ zur Erzeugung der Magnetfelder der Stärke $H_e$ erforderlich würden. Im allgemeinen beträgt der Abstand D nur wenige μm. Gegebenenfalls kann der Leiterbahnteil $L_j$ auch direkt an dem Sensorelement $E_j$ bzw. dessen Schicht 5 anliegen.

Abweichend von dem gemäß Figur 2 dargestellten Leiterbahnträger 8 sind selbstverständlich auch andere Halterungsmittel zu einer Positionierung der Leiterbahnteile bezüglich des jeweils mindestens einen zugeordneten Sensorelementes geeignet.

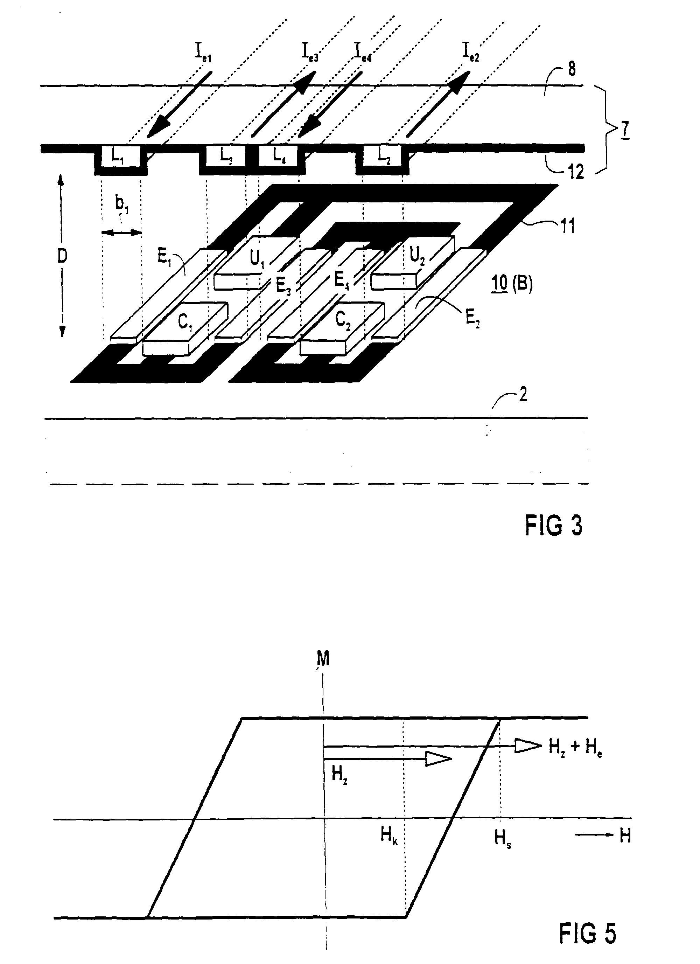

Figur 3 zeigt eine entsprechende Einstellvorrichtung 7 für einen Magnetfeldsensor 10 mit vier GMR-Mehrschichtensensorelementen $E_1$ bis $E_4$, die vorzugsweise nebeneinander auf einem gemeinsamen Substrat 2 angeordnet sind. Selbstverständlich können für die Sensorelemente auf dem Substrat auch andere Anordnungsmöglichkeiten gewählt werden. Die gezeigten Sensorelemente $E_1$ bis $E_4$ sind untereinander und mit Kontaktierungsflächen der Anschlußpunkte $C_1$, $C_2$ und $U_1$, $U_2$, sogenannten Kontaktpads, mittels Kontaktbahnen 11 zu der Brücke B gemäß Figur 1 verschaltet. Jedem Sensorelement $E_j$ ist ein Leiterbahnteil $L_j$ (mit $1 \leq j \leq 4$) an der Unterseite eines Leiterbahnträgers 8 der Einstellvorrichtung 7 zugeordnet. Die Leiterbahnteile $L_j$ können zusätzlich mit einer Isolatorschicht 12 versehen sein, um Kurzschlüsse zwischen benachbarten Leiterbahnteilen auszuschließen. Die Lage der einzelnen Leiterbahnteile $L_j$ an dem Leiterbahnträger 8 ist dabei so gewählt, daß bei einem Heranführen der Einstellvorrichtung 7 an den Magnetfeldsensor 10 die einzelnen Leiterbahnteile $L_j$ genau parallel zu den jeweils zugeordneten Sensorelementen $E_j$ unter Einhaltung eines sehr geringen Abstandes D von im allgemeinen einigen µm verlaufen. Die einzelnen Leiterbahnteile $L_1$ bis $L_4$ mit beispielsweise gleichen Leiterbahnbreiten $b_1$ bis $b_4$ sind von Einstellströmen $I_{e1}$ bis $I_{e4}$ in den durch Pfeile angedeuteten Stromflußrichtungen durchflossen, um in den einzelnen Sensorelementen die gewünschten Biasschichtorientierungen herbeizuführen.

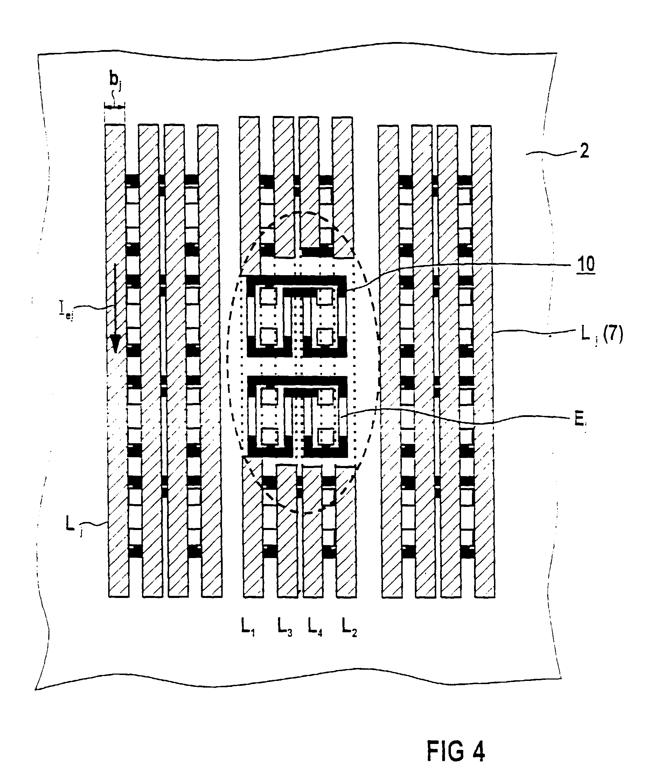

Zu einer wirtschaftlichen Herstellung entsprechender Magnetfeldsensoren 10 werden vorteilhaft eine Vielzahl von Einzelsensoren auf einem gemeinsamen Substrat, beispielsweise einer Siliziumscheibe, gleichzeitig hergestellt. Ein entsprechendes Ausführungsbeispiel mit mehreren Magnetfeldsensoren auf einem scheibenförmigen Si-Substrat 2 ist Figur 4 zugrundegelegt. Die Biasschichtteile der einzelnen GMR-Sensorelemente $E_j$ dieser Magnetfeldsensoren 10 werden mittels hinreichend hoher Einstellströme $I_{ej}$ in den jeweils zugeordneten Leiterbahnteilen $L_j$ bzw. $L_1$ bis $L_4$ einer erfindungsgemäßen Einstellvorrichtung erzeugt. Dabei können mehrere Leiterbahnteile für mehrere Sensorelemente von durchgehenden Leiterbahnen $L_j$ gebildet werden. Das von diesen Leiterbahnen hervorzurufende magnetische Einstellfeld $H_e$ muß in vielen Fällen verhältnismäßig hoch sein und kann beispielsweise 0,8 bis 1,6 kA/cm (1 bis 2 kOe) betragen. Die Stromstärke pro µm der Leiterbahnbreite $b_j$ beträgt dann ungefähr 150 bis 300 mA. Für typische Leiterbahnbreite $b_j$ von 50 µm ergibt sich dann ein Strom $I_{ej}$ von 7 bis 15 A. Ein solch hoher Strom führt zu einer erheblichen Wärmebelastung der Leiterbahn und bringt die Gefahr eines Durchbrennens bei kontinuierlicher Belastung mit sich. Vorteilhaft kann deshalb ein pulsierender Einstellstrom $I_{ej}$ mit kurzer Pulsdauer von z.B. unter 100 ms vorgesehen werden. Ferner wird vorteilhaft die Dicke der Leiterbahnen bzw. ihrer Leiterbahnteile $L_j$ möglichst groß gewählt, weil zum einen der Widerstand und somit auch die Wärmeerzeugung umgekehrt proportional zur Dicke ist und weil zum anderen die Wärmekapazität proportional mit der Dicke zunimmt. Den konkret erreichbaren Leiterbahndicken sind jedoch durch die angewandte Technologie Grenzen gesetzt. Darüber hinaus ist vorteilhaft auch eine Wärmeabfuhr der von den Leiterbahnen erzeugten Wärme mittels Wärmeleitung über den Leiterbahnträger möglich. Dieser Träger sollte deshalb zweckmäßig aus einem thermisch gut leitenden Material bestehen und gegebenenfalls gekühlt werden.

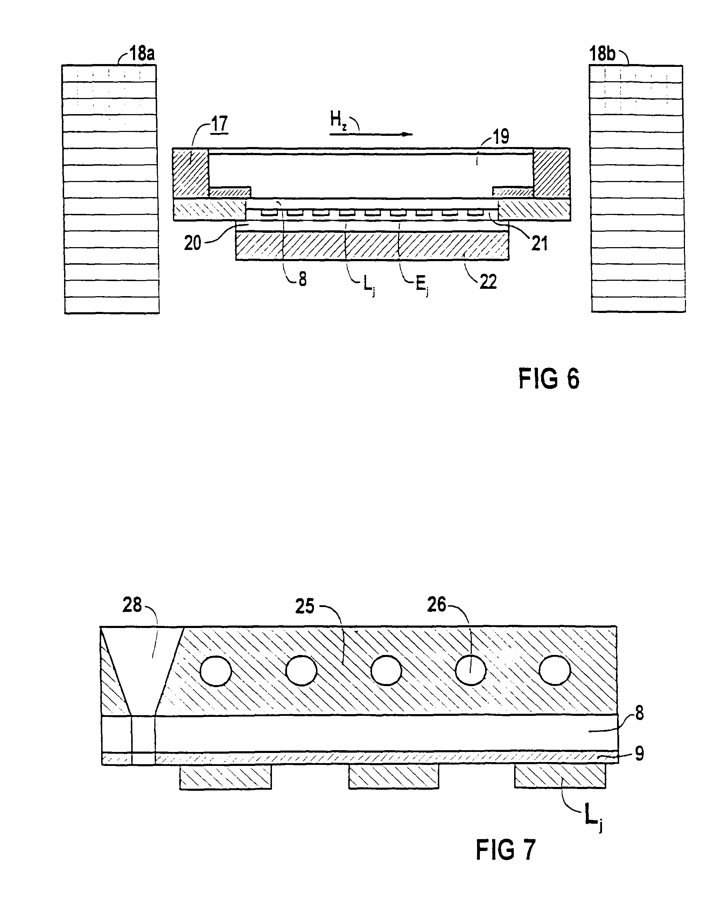

Eine weitere Möglichkeit zu einer Erniedrigung des Einstellstromes in den Leiterbahnen besteht darin, daß man zusätzlich ein äußeres Stützfeld der Stärke $H_z$ anlegt. Dieses Stützfeld soll parallel oder antiparallel zu dem von dem jeweiligen Leiterbahnteil $L_j$ hervorgerufenen Einstellfeld $H_e$ gerichtet sein. Das Stützfeld $H_z$ und das Einstellfeld $H_e$ ermöglichen dann ein notwendiges Überschreiten eines vorbestimmten Schwellwertes der Feldstärke des Magnetfeldes, dem sich der Biasschichtteil des GMR-Mehrschichtensystems ausgesetzt sieht. Entsprechende Feldverhältnisse, wie sie für eine Biasschicht oder für ein System eines künstlichen Antiferromagneten (vgl. DE 42 43 358 A1) typisch sind, gehen aus dem Diagramm der Figur 5 hervor. In diesem Diagramm sind jeweils in willkürlichen Einheiten in Richtung der Abszisse die Feldstärke H und in Richtung der Ordinate die Magnetisierung M aufgetragen. Für die dargestellte Hysteresiskurve stellen die Größen $H_s$ eine Schwellwertfeldstärke, die gemäß dem angenommenen Ausführungsbeispiel die Sättigungsfeldstärke sein kann, ferner $H_c$ die Koerzitivfeldstärke und $H_k$ die Feldstärke dar, bei der sich die Magnetisierung M vom Wert der negativen Sättigungsmagnetisierung mit zunehmender Feldstärke sprunghaft zu erhöhen beginnt. $H_z$ wird ungefähr gleich $(H_k + H_s)/2$ gewählt. Die Summe der Beträge von $H_z$ und dem Einstellfeld $H_e$ ist größer als die Sättigungsfeldstärke $H_s$, während $|\,|H_z| - |H_e|\,|$ kleiner als $H_k$ ist. $H_z$ und $H_e$ sind dabei parallelgerichtet. Die Richtung $H_z$ wird während der Einstellung umgekehrt. In einer ersten Einstellphase sind $H_e$ und $H_z$ an den Leiterbahnen $L_1$ und $L_4$ (gemäß Figur 3) gleichgerichtet, und es wird in den entsprechenden Sensorelementen $E_1$ und $E_4$ die Biasschichtmagnetisierung eingestellt. In den anderen Elementen $E_2$ und $E_3$ herrscht hingegen ein Feld $|H_z| - |H_e|$ , das zu gering ist, um die Biasschichtmagnetisierungen in diesen Elementen zu beeinträchtigen. Bei entgegengesetztem $H_z$ vertauschen sich die Rollen der Elementpaare $E_1$-$E_4$ und $E_2$-$E_3$, so daß die Elemente $E_2$ und $E_3$ dann in die Gegenrichtung magnetisiert werden. Für den Fall, daß $H_k = H_s/2$ ist und $H_e \approx 1,1 * (H_s - H_k)/2$ ist, reduziert sich die Einstellstromstärke um einen Faktor 1,1:4. Bei gleicher Leiterbahngeometrie ist dann die erzeugte Wärme um einen Faktor 1:9 geringer.

Bei einigen Mehrschichtensystemen, insbesondere sogenannten "Exchange-Biased-Systemen" mit Biasschichtteil aus einer NiFe-Schicht mit FeMn-Unterlage (vgl. z.B. EP 0 346 817 A2), kann es vorteilhaft sein, das Schichtsystem während der Magnetisierung seines Biasschichtteils erhöhten Temperaturverhältnissen auszusetzen. So ist z.B. für die erwähnte FeMn-Schicht des Schichtsystems eine Temperaturerhöhung auf etwa 150°C günstig. Eine entsprechende Temperaturerhöhung kann durch Anordnung des Schichtsystems in einem geheizten Raum erfolgen.

Gemäß dem dem Diagramm der Figur 5 zugeordneten Ausführungsbeispiel wurde davon ausgegangen, daß ein äußeres magnetisches Stützfeld mit einer solchen Feldstärke $H_z$ gewählt wird, daß mit ihm allein die Schwellwertfeldstärke $H_s$ nicht zu überschreiten ist. Selbstverständlich ist es auch möglich, ein entsprechend hohes magnetisches Stützfeld vorzusehen und dann mit dem Einstellfeld einer Leiterbahn $L_j$ der erfindungsgemäßen Vorrichtung ein Gegenfeld aufzubauen, daß das Stützfeld entsprechend vermindert.

Figur 6 zeigt die wesentlichen Teile einer erfindungsgemäßen Vorrichtung zur Einstellung der Biasschichtmagnetisierung von GMR-Sensorelementen. Der Aufbau dieser allgemein mit 17 bezeichneten Vorrichtung ähnelt dem von bekannten optischen Kontaktbelichtungsanlagen, die in der Mikrostrukturtechnik Anwendung finden. Auf die Unterscheidungsmerkmale der erfindungsgemäßen Magnetisierungsvorrichtung gegenüber diesen bekannten Anlagen sei nachfolgend eingegangen. Dabei sind in der Figur bezeichnet mit 18a und 18b eine magnetische Feldquelle, mit 19 eine Kühlungskammer, mit 20 ein Sensorsubstrat mit darauf befindlichen, in der Figur nur angedeuteten GMR-Sensorelementen $E_j$, mit 21 ein entlüftbarer Zwischenraum und mit 22 eine Einrichtung zur Positionierung des Sensorsubstrats 20 bezüglich eines Leiterbahnträgers 8 mit Leiterbahnen $L_j$.

Als Feldquelle zur Erzeugung des Zusatzfeldes $H_z$ können gemäß dem dargestellten Ausführungsbeispiel Dauermagnete 18a und 18b vorgesehen werden, zwischen deren Magnetpolen die Leiterbahnen $L_j$ und die zugeordneten Sensorelemente verlaufen. Eine Feldumkehrung kann z.B. durch Drehung des gesamten Magnetsystems um eine Achse senkrecht zum Feld der Leiterbahnen $L_j$ erfolgen. Man kann aber auch zwei getrennte Magnetfeldbereiche mit entgegengesetzten Feldrichtungen vorsehen, in die der Aufbau mit dem Leiterbahnträger und dem Sensorsubstrat nacheinander eingebracht werden. Selbstverständlich sind zur Erzeugung des Feldes $H_z$ auch magnetische Feldspulen geeignet, die beispielsweise den Leiterbahnträger und das zugeordnete Sensorsubstrat umschließen.

Ferner ist gegebenenfalls ein leistungsstarker Pulsgenerator mit Anschlüssen zu den Leiterbahnträgern erforderlich. Da die Einstellströme verhältnismäßig hoch sind, werden zuverlässige niederohmige Kontakte notwendig. Eine geeignete Bondung oder Lötung von Anschlußdrähten an den Leiterbahnträger läßt sich wegen einer vorteilhaften Mehrfachnutzung jeder Leiterbahnkonfiguration durchführen.

Außerdem kann es zweckmäßig sein, einen entlüftbaren Zwischenraum 21 vorzusehen, um den Abstand zwischen dem Sensorsubstrat 20 und dem Leiterbahnträger 8 über der ganzen Kontaktfläche genügend gering halten zu können. Zur Unterdruckerzeugung wird beispielsweise die Luft aus dem Zwischenraum abgesaugt. Es sind so die Anforderungen für den Leiterbahnträger-Sensorsubstratabstand D verhältnismäßig leicht zu erfüllen, wobei D in der Größenordnung von 10 μm liegt. Nur bei Sensoren mit sehr kleinen lateralen Abmessungen und bei unebenen Sensorsubstraten können Probleme auftreten. In diesem Fall sind flexible Träger und/oder Sensorsubstrate anwendbar. Der Unterdruck in dem Zwischenraum 21 sorgt dann dafür, daß der Leiterbahnträger und das Sensorsubstrat sich gegenseitig in ihrer Form anpassen.

Darüber hinaus ist vorteilhaft eine Kühlung des Leiterbahnträgers 8 möglich. Gemäß Figur 6 kann hierzu der Kühlungsraum 19 dienen, durch den ein flüssiges oder gasförmiges Kühlmedium geführt werden kann.

Zusätzlich oder stattdessen ist auch ein Kühlkörper mit einer großen Wärmekapazität zur Wärmeabfuhr geeignet. Ein entsprechendes Ausführungsbeispiel zeigt Figur 7. Dementsprechend ist an einen Leiterbahnträger 8 auf dessen den Leiterbahnen $L_j$ abgewandter Seite ein Kühlkörper 25 angesetzt, der zusätzlich noch mit Kühlkanälen 26 zur Führung eines Kühlmittels versehen sein kann. Wie aus der Figur ferner zu entnehmen ist, weist der Kühlkörper 25 ein Justierloch 28 auf. Damit ist eine optische Justierung des Kühlkörpers bzw. seiner mit ihm verbundenen Leiterbahnen bezüglich einer entsprechenden Markierung auf der Oberfläche eines Sensorsubstrates möglich. Ähnliche optische Verfahren werden in der Mikrostrukturtechnik eingesetzt, um eine meistens durchsichtige Kontaktmaske bezüglich eines Wafers zu positionieren. Wegen des im allgemeinen nicht-transparenten Leiterbahnträgers 8 und des Kühlkörpers 25 wird hier das Justierloch 28 erforderlich. Die geforderte Positioniergenauigkeit braucht nicht die in der Mikrostrukturtechnik üblichen Forderungen zu erfüllen. Deswegen kommen auch andere nicht-optische Verfahren wie z.B. elektrische Kontakte zur Justierung in Frage.

**Patentansprüche**

1. Vorrichtung zur Einstellung der Magnetisierungen der Bias-schichtteile in zu einer Brücke verschalteten magnetoresistiven Sensorelementen, die jeweils mit demselben Dünnschichtaufbau auf einem gemeinsamen Substrat angeordnet sind und einen gegenüber einem AMR-Sensorelement erhöhten magnetoresistiven Effekt zeigen, welche Vorrichtung

    - mehrere von den Sensorelementen ($E_j$) räumlich getrennte Leiterbahnteile ($L_j$) mit einer solchen Anordnung aufweist, daß bei einer vorbestimmten Position der Leiterbahnteile ($L_j$) bezüglich der Sensorelemente ($E_j$) der Brückenschaltung (B) jeweils ein Leiterbahnteil ($L_j$) mindestens einem Sensorelement ($E_j$) zugeordnet ist, und
    - Mittel enthält zur Führung eines Einstellstromes ($I_e$, $I_{ej}$) vorbestimmter Richtung und Stärke derart über jeden Leiterbahnteil ($L_j$), daß in dem Biasschichtteil (3) des jeweils mindestens einen zugeordneten Sensorelementes ($E_j$) eine vorbestimmte Orientierungsrichtung der Magnetisierung ($m_{fj}$) fest einstellbar ist.

2. Vorrichtung nach Anspruch 1, **dadurch gekennzeichnet,** daß die Leiterbahnteile ($L_j$) jeweils zumindest annähernd parallel zu mindestens einem zugeordneten Sensorelement ($E_j$) anordbar sind.

3. Vorrichtung nach Anspruch 1 oder 2, **dadurch ge-**

**kennzeichnet,** daß mittels des Einstellstromes ($I_e$) in dem jedem zugeordneten Sensorelement ($E_j$) zugeordneten Leiterbahnteil ($L_j$) der Biasschichtteil (3) des Elementes einem Magnetfeld mit einer die feste Einstellung der Orientierungsrichtung der Magnetisierung ($m_{fj}$) des Biasschichtteils ermöglichenden Stärke ($H_e$) auszusetzen ist.

4. Vorrichtung nach Anspruch 1 oder 2, **dadurch gekennzeichnet,** daß jedes Sensorelement ($E_j$) einem von einer magnetischen Feldquelle (18a, 18b) hervorgerufenen Stützfeld solcher Stärke ($H_z$) auszusetzen ist, daß dieses Stützfeld bei Überlagerung mit dem mittels des Einstellstromes ($I_e$) in dem Leiterbahnteil ($L_j$) zu erzeugenden Magnetfeldes ($H_e$) die feste Einstellung der Orientierungsrichtung der Magnetisierung ($m_{fj}$) des Biasschichtteiles (3) ermöglicht.

5. Vorrichtung nach Anspruch 4, **dadurch gekennzeichnet ,** daß von den in dem Stützfeld der vorbestimmten Stärke ($H_z$) gemeinsam befindlichen Sensorelementen ($E_j$) in den Basisschichtteilen (3) von zwei Elementen ($E_1$, $E_4$) aufgrund der vorbestimmten Einstellströme ($I_{e1}$ bzw. $I_{e2}$) in den ihnen zugeordneten Leiterbahnteilen ($L_1$ bzw. $L_4$) zugleich die vorbestimmte Orientierungsrichtung der Magnetisierung ($m_{fj}$) einstellbar ist, während in den anderen Elementen ($E_2$, $E_3$) aufgrund anderer Einstellströme ($I_{e2}$ bzw. $I_{e3}$) in den ihnen zugeordneten Leiterbahnteilen ($L_2$ bzw. $L_3$) keine Orientierung möglich ist.

6. Vorrichtung nach einem der Ansprüche 1 bis 5, **dadurch gekennzeichnet,** daß Mittel zur Einstellung einer Temperatur von etwa 150°C bei der Orientierung der Biasschichtteile (3) der Sensorelemente ($E_j$) vorgesehen sind.

7. Vorrichtung nach einem der Ansprüche 1 bis 6, **gekennzeichnet** durch einen pulsierenden Einstellstrom ($I_e$).

8. Vorrichtung nach einem der Ansprüche 1 bis 7, **dadurch gekennzeichnet,** daß die Leiterbahnteile ($L_j$) aus einem elektrisch gut leitenden Material bestehen.

9. Vorrichtung nach einem der Ansprüche 1 bis 8, **dadurch gekennzeichnet,** daß die Leiterbahnteile ($L_j$) an einem gemeinsamen Leiterbahnträger (8) befestigt sind.

10. Vorrichtung nach Anspruch 9, **dadurch gekennzeichnet,** daß der Leiterbahnträger (8) aus einem thermisch gut leitenden Material besteht zur Wärmeabfuhr der von den Leiterbahnteilen ($L_j$) erzeugten Wärme mittels Wärmeleitung über den Leiterbahnträger.

11. Vorrichtung nach Anspruch 9 oder 10, **dadurch gekennzeichnet,** daß Mittel zur Kühlung des Leiterbahnträgers (8) vorgesehen sind.

12. Vorrichtung nach Anspruch 11, **dadurch gekennzeichnet ,** daß der Leiterbahnträger auf seiner den Leiterbahnteilen abgewandten Seite mit einem Kühlkörper (25) mit Kühlkanälen (26) für ein Kühlmittel verbunden ist.

13. Vorrichtung nach einem der Ansprüche 9 bis 12, **dadurch gekennzeichnet,** daß Mittel zur Justierung des Leiterbahnträgers (8) oberhalb der Sensorelemente ($E_j$) der Brückenschaltung (B) vorgesehen sind.

14. Vorrichtung nach einem der Ansprüche 1 bis 13, **gekennzeichnet durch** eine Zuordnung zu Sensorelementen ($E_j$), die in der Brückenschaltung (B) nebeneinander angeordnet sind.

**Claims**

1. A device for setting the magnetisations of the bias-layer parts in magneto-resistive sensor elements which are interconnected to form a bridge and arranged in each case with the same thin-film structure on a common substrate and which display an increased magneto-resistive effect in comparison with an AMR sensor element, which device

   - has a plurality of conductive-track parts ($L_j$) which are separated in space from the sensor elements ($E_j$), with such an arrangement that, with a predetermined position of the conductive-track parts ($L_j$) with respect to the sensor elements ($E_j$) of the bridge circuit (B), in each case one conductive-track part ($L_j$) is associated with at least one sensor element ($E_j$), and

   - contains means for conducting a set current ($I_e$, $I_{ej}$) of a predetermined direction and strength in such a manner over each conductive-track part ($L_j$) that a predetermined direction of orientation of the magnetisation ($m_{fj}$) can be permanently set, in the bias-layer part (3) of in each case at least one associated sensor element ($E_j$).

2. A device according to claim 1, characterised in that the conductive-track parts ($L_j$) can in each case be arranged at least approximately parallel to at least one associated sensor element ($E_j$).

3. A device according to claim 1 or 2, characterised in that by means of the set current ($I_e$) the bias-layer

part (3) of the element is to be subjected to a magnetic field having a strength ($H_e$) which permits the setting in a fixed manner of the direction of orientation of the magnetisation ($m_{fj}$) of the bias-layer part in the conductive-track part ($L_j$) associated with each associated sensor element ($E_j$).

4. A device according to claim 1 or 2, characterised in that each sensor element ($E_j$) is subjected to a supporting field, caused by a magnetic field source (18a, 18b), which is of such strength ($H_Z$) that when the magnetic field ($H_e$) to be produced by means of the set current ($I_e$) in the conductive-track part ($L_j$) is superimposed on said supporting field, it allows the direction of orientation of the magnetisation ($m_{fj}$) of the bias-layer part (3) to be permanently set.

5. A device according to claim 4, characterised in that the predetermined direction of orientation of magnetisation ($m_{fj}$) of two elements ($E_1$, $E_4$) among the sensor elements ($E_j$) present jointly in the supporting field of predetermined strength ($H_Z$) in the base layer parts (3) can be set at the same time due to the predetermined set currents ($I_{e1}$ and $I_{e2}$) in the conductive-track parts ($L_1$ and $L_4$) associated with them, while in the other elements ($E_2$, $E_3$) no orientation is possible, due to other set currents ($I_{e2}$ and $I_{e3}$), in the conductive-track parts ($L_2$ and $L_3$) associated with them.

6. A device according to any of claims 1 to 5, characterised in that means are provided for setting a temperature of about 150°C at the time of orientation of the bias-layer parts (3) of the sensor elements ($E_j$).

7. A device according to any of claims 1 to 6, characterised by a pulsating set current ($I_e$).

8. A device according to any of claims 1 to 7, characterised in that the conductive-track parts ($L_j$) consist of an electrically well-conducting material.

9. A device according to any of claims 1 to 8, characterised in that the conductive-track parts ($L_j$) are fastened on a common conductive-track support (8).

10. A device according to claim 9, characterised in that the conductive-track support (8) consists of a thermally well-conducting material for carrying off the heat generated by the conductive-track parts ($L_j$) by thermal conduction via the conductive-track support.

11. A device according to claim 9 or 10, characterised in that means are provided for cooling the conductive-track support (8).

12. A device according to claim 11, characterised in that the conductive-track support is connected on its side facing away from the conductive-track parts with a cooling body (25) having cooling channels (26) for a coolant.

13. A device according to any of claims 9 to 12, characterised in that means are provided for adjusting the conductive-track support (8) above the sensor elements ($E_j$) of the bridge circuit (B).

14. A device according to any of claims 1 to 13, characterised by an association with sensor elements ($E_j$) which are arranged alongside of each other in the bridge circuit (B).

**Revendications**

1. Dispositif pour le réglage de la magnétisation des parties formant couches de polarisation dans des éléments de capteur magnétorésistif raccordés en pont, qui sont chacun disposés dans la même structure en couche mince sur un substrat commun et qui présentent un effet magnétorésistif accru par rapport à un élément de capteur AMR, lequel dispositif présente:

   - plusieurs parties formant bande conductrice ($L_j$) séparées spatialement par les éléments de capteur ($E_j$) dans un agencement tel que pour une position prédéterminée des parties formant bande conductrice ($L_j$) par rapport aux éléments de capteur ($E_j$) du circuit de pont (B), une partie formant bande conductrice ($L_j$) étant chaque fois associée à au moins un élément de capteur ($E_j$), et
   - contient des moyens pour le guidage d'un courant de réglage ($I_e$, $I_{ej}$) de direction et d'intensité prédéterminées dans chaque partie formant bande conductrice ($L_j$), de telle sorte que dans la partie formant couche de polarisation (3) de chaque, au moins un, élément de capteur ($E_j$) associé, une direction prédéterminée d'orientation de la magnétisation ($m_{fj}$) peut être réglée de manière fixe.

2. Dispositif selon la revendication 1, caractérisé en ce que les parties formant bande conductrice ($L_j$) peuvent être disposées chacune au moins sensiblement en parallèle à moins un élément de capteur ($E_j$) associé.

3. Dispositif selon la revendication 1 ou 2, caractérisé en ce qu'au moyen d'un courant de réglage ($I_e$) dans la partie formant bande conductrice ($L_j$) associée à chaque élément de capteur ($E_j$) associé, la partie formant couche de polarisation (3) de l'élément, est exposée à un champ magnétique d'une intensité ($H_e$) permettant le réglage fixe de la direction d'orientation de la magnétisation ($m_{fj}$) de la partie formant couche de polarisation.

4. Dispositif selon la revendication 1 ou 2, caractérisé en ce que chaque élément de capteur ($E_j$) est exposé à un champ d'appui provoqué par une source de champ magnétique (18a, 18b) d'une intensité ($H_z$) telle que ce champ d'appui permet le réglage fixe de la direction d'orientation de la magnétisation ($m_{fj}$) de la partie formant couche de polarisation (3) en cas de superposition avec le champ magnétique ($H_e$) à créer au moyen du courant de réglage ($I_e$) dans la partie formant bande conductrice ($L_j$).

5. Dispositif selon la revendication 4, caractérisé en ce que la direction d'orientation prédéterminée de la magnétisation ($m_{fj}$) peut être réglée en même temps par les éléments de capteur ($E_j$) situés ensemble dans le champ d'appui d'intensité ($H_z$) prédéterminée dans les parties formant couche de polarisation (3) de deux éléments ($E_1$, $E_4$) sur base des courants prédéterminés de réglage ($I_{e1}$, resp. $I_{e2}$) dans les parties formant bande conductrice ($L_1$, resp. $L_4$) qui leur sont associées, tandis que dans les autres éléments ($E_2$, $E_3$), aucune orientation n'est possible sur base d'autres courants de réglage ($I_{e2}$, resp. $I_{e3}$) dans les parties formant bande conductrice ($L_2$, resp. $L_3$) qui leur sont associées.

6. Dispositif selon l'une des revendications 1 à 5, caractérisé en ce que sont prévus des moyens pour le réglage d'une température d'environ 150°C lors de l'orientation des parties formant couche de polarisation (3) des éléments de capteur ($E_j$).

7. Dispositif selon l'une des revendications 1 à 6, caractérisé par un courant de réglage ($I_e$) pulsé.

8. Dispositif selon l'une des revendications 1 à 7, caractérisé en ce que les parties formant bande conductrice ($L_j$) sont constituées d'un matériau électriquement bon conducteur.

9. Dispositif selon l'une des revendications 1 à 8, caractérisé en ce que les parties formant bande conductrice ($L_j$) sont fixées sur un support commun (8) de bandes conductrices.

10. Dispositif selon la revendication 9, caractérisé en ce que le support (8) de bandes conductrices est constitué d'un matériau thermiquement bon conducteur, pour l'évacuation de la chaleur créée par les parties formant bande conductrice ($L_j$), par conduction thermique par l'intermédiaire du support de bandes conductrices.

11. Dispositif selon la revendication 9 ou 10, caractérisé en ce que sont prévus des moyens pour le refroidissement du support (8) de bandes conductrices.

12. Dispositif selon la revendication 11, caractérisé en ce que sur son côté non tourné vers les parties formant bande conductrice, le support de bandes conductrices est relié à un corps de refroidissement (25) présentant des canaux de refroidissement (26) pour un fluide de refroidissement.

13. Dispositif selon l'une des revendications 9 à 12, caractérisé en ce que des moyens sont prévus pour l'ajustement du support (8) de bandes conductrices au-dessus des éléments de capteur ($E_j$) du circuit de pont (B).

14. Dispositif selon l'une des revendications 1 à 13, caractérisé par une conjugaison à des éléments de capteur ($E_j$) qui sont disposés les uns à côté des autres dans le circuit de pont (B).

FIG 1

FIG 2

$I_{e1}$  $I_{e3}$  $I_{e4}$  $I_{e2}$

8

7

$L_1$  $L_3$  $L_4$  $L_2$

12

$b_1$

11

D

$E_1$  $U_1$  $U_2$

$E_3$  $E_4$

$C_1$  $C_2$  10 (B)

$E_2$

2

**FIG 3**

M

$H_z + H_e$

$H_z$

$H_k$  $H_s$  H

**FIG 5**

FIG 4

18a

18b

17

$H_z$

19

20

8

$L_j$

$E_j$

22

21

**FIG 6**

28

25

26

8

9

$L_j$

**FIG 7**